# EUROPÄISCHE PATENTSCHRIFT

(11) **EP 2 859 366 B1**
(45) Veröffentlichungstag und Bekanntmachung des Hinweises auf die Patenterteilung: **12.10.2016**
(21) Anmeldenummer: 13724602.1
(22) Anmeldetag: 24.05.2013
(51) Int. Cl.: H01M 10/42, H01M 10/48, G01R 31/36

(54) **VERFAHREN UND VORRICHTUNG ZUR ERMITTLUNG DES INNENWIDERSTANDES VON BATTERIEZELLEN EINER BATTERIE**
METHOD AND A DEVICE FOR DETERMINING THE INTERNAL RESISTANCE OF BATTERY CELLS OF A BATTERY
PROCÉDÉ ET DISPOSITIF DE DÉTERMINATION DE LA RÉSISTANCE INTERNE D'ÉLÉMENTS DE BATTERIE D'UNE BATTERIE

(30) Priorität: 08.06.2012 DE 102012209657
(43) Veröffentlichungstag der Anmeldung: 15.04.2015
(73) Patentinhaber: Robert Bosch GmbH, 70442 Stuttgart (DE); Samsung SDI Co., Ltd., Yongin-si, Gyeonggi-do 446-577 (KR)
(72) Erfinder: FINK, Holger, 70567 Stuttgart (DE)
(74) Vertreter: Bee, Joachim
(86) Internationale Anmeldenummer: PCT/EP2013/060748
(87) Internationale Veröffentlichungsnummer: WO 2013/182436

(56) Entgegenhaltungen:
- DE-A1-102009 054 546
- DE-A1-102010 027 864
- US-A1- 2012 119 745

## Beschreibung

Die vorliegende Erfindung betrifft ein Verfahren und eine entsprechende Vorrichtung zur Ermittlung des Innenwiderstandes der Batteriezellen der in mindestens einem Batteriestrang angeordneten Batteriemodule einer mit einem Elektromotor verbundenen Batterie, wobei die Batteriemodule zur Erzeugung einer einstellbaren Ausgangsspannung der Batterie jeweils zu dem mindestens einen Batteriestrang der Batterie seriell zuschaltbar und von dem Batteriestrang entkoppelbar ausgebildet sind. Ferner betrifft die Erfindung eine Batterie, die jeweils mindestens eine Batteriezelle aufweisende Batteriemodule umfasst, die in mindestens einem Batteriestrang angeordnet sind und zur Erzeugung einer einstellbaren Ausgangsspannung der Batterie zu dem Batteriestrang der Batterie seriell zuschaltbar und von dem Batteriestrang entkoppelbar ausgebildet sind. Außerdem betrifft die Erfindung ein Kraftfahrzeug mit einer derartigen Batterie.

### Stand der Technik

Aus dem Stand der Technik sind Batterien für den Einsatz in Hybrid- und Elektrofahrzeugen bekannt, die als Traktionsbatterien bezeichnet werden, da sie für die Speisung elektrischer Antriebe eingesetzt werden.

Die Druckschrift D1 offenbart ein Batterieüberwachungssystem zur Bestimmung eines Innenwiderstands einer Batteriezelle eines Batteriesystems und eines Spannungsabfalls an der Batteriezelle.

In einer früheren Patentanmeldung der Anmelderin wurde ein Batteriesystem mit einer Batterie mit einer stufig einstellbaren Ausgangsspannung beschrieben. Bei der Batterie dieses Batteriesystems werden die Batteriezellen nicht lediglich in Reihe geschaltet. Vielmehr ist das Batteriesystem aus Batteriemodulen mit in Serie und/oder parallel geschalteten Batteriezellen aufgebaut. Solche Batteriemodule können über spezielle Koppeleinheiten zu einem einzelnen Batteriestrang seriell zugeschaltet oder überbrückt werden. Eine einstellbare Ausgangsspannung einer Batterie eines solchen Batteriesystems kann dadurch erreicht werden, dass geeignet viele Batteriemodule zu dem Batteriestrang zugeschaltet oder überbrückt werden. Derartige Batteriesysteme werden dabei auch als Batteriedirektkonverter bezeichnet.

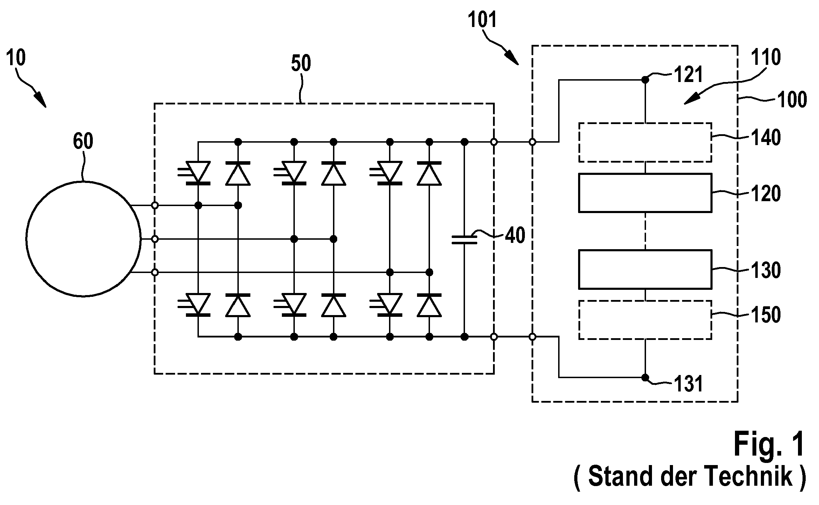

Das Prinzipschaltbild eines solchen Antriebssystems mit einem Batteriedirektkonverter ist in der Figur 1 dargestellt. Gemäß der Figur 1 umfasst ein Antriebssystem 10 ein Batteriesystem 101 mit einer Batterie 100, die mit einem Batteriedirektkonverter betrieben wird und an einen Gleichspannungszwischenkreis (nicht gekennzeichnet), der einen Kondensator 40 umfasst, angeschlossen ist. Ebenfalls an den Gleichspannungszwischenkreis angeschlossen ist ein von dem Batteriesystem 101 umfasster Pulswechselrichter 50, der für den Betrieb eines dreiphasigen Elektromotors 60 beziehungsweise Antriebsmotors an drei Ausgängen über jeweils zwei schaltbare Halbleiterventile (nicht gekennzeichnet) und zwei Dioden (nicht gekennzeichnet) gegeneinander phasenversetzte Sinusspannungen bereitstellt. Dabei muss die Kapazität des Kondensators 40 hinreichend groß sein, um die Spannung im Gleichspannungszwischenkreis für eine Zeitdauer, in der eines der schaltbaren Halbleiterventile durchgeschaltet wird, zu stabilisieren. In einer praktischen Anwendung, wie beispielsweise in einem Betrieb in einem Elektrofahrzeug, erfordert dies im Allgemeinen eine hohe Kapazität im Bereich von typischerweise mehreren mF.

Die Batterie 100 umfasst einen Batteriestrang 110 mit mehreren in Reihe geschalteten Batteriemodulen, von denen in der Zeichnung nur zwei Batteriemodule 120, 130 dargestellt sind. Zwischen einem Batteriemodul 120 und einem positiven Pol 121 des Batteriestranges 110, der in diesem Fall das positive Batterieterminal bildet, kann eine Lade- und Trenneinrichtung 140 geschaltet sein. Optional kann zusätzlich zwischen einem weiteren Batteriemodul 130 und einem negativen Pol 131 der des Batteriestranges 110, der in diesem Fall das negative Batterieterminal bildet, eine Trenneinrichtung 150 geschaltet sein. Die Trenn- und Ladeeinrichtungen 140, 150 sind jeweils dazu ausgebildet, die mittels einer Koppeleinrichtung (nicht dargestellt) an den Batteriestrang 110 koppelbaren Batteriemodule 120, 130 von den Batterieterminals 121, 131 abzutrennen, um dadurch die Batterieterminals 121, 131 spannungsfrei zu schalten.

Wie ferner bekannt ist, werden bei Lithium-Ionen-Batterien in einem Batteriemodul 6 bis 12 Batteriezellen zusammengefasst. Dies entspricht einer Batteriemodulspannung im Bereich von circa 18 V, beispielsweise im Fall, wenn nur 6 Batteriezellen vollständig geladen sind, wohingegen 6 Batteriezellen entladen sind, bis 50 V, im Fall, wenn 12 Batteriezellen vollständig geladen sind.

In einer anderen Patentanmeldung der Anmelderin wird ein Verfahren zur Ermittlung des Innenwiderstandes der in der Batterie eines Batteriedirektkonverters enthaltenen Batteriezellen oder Batteriemodule beschrieben. Das dortige Verfahren ist dadurch bestimmt, dass sich die Ausgangsspannung der Batterie des Batteriedirektkonverters während der Bestimmung des Innenwiderstands der in der Batterie vorhandenen Batteriezellen oder Batteriemodule ändert, was sich in vielen Fällen als Nachteil auswirken kann und abhängig von dem Betriebszustand des Antriebs zu Problemen führen beziehungsweise nicht tolerierbar sein kann. So kann ein Batteriedirektkonverter, bei dem das genannte Verfahren zur Ermittlung des Innenwiderstands der in der Batterie des Batteriedirektkonverters enthaltenen Batteriezellen oder Batteriemodule durchgeführt wird, nicht beliebig in Zusammenhang mit Invertern, Elektromaschinen und deren zugehörigen Regel-und Führungssystemen eingesetzt werden.

In Batteriesystemen, die gemäß der Architektur eines Batteriedirektkonverters aufgebaut sind, besteht die Möglichkeit, dass die Batteriemodule einzeln zu dem Batteriestrang zugeschaltet und von dem Batteriestrang entkoppelt werden. Dies kann dazu genutzt werden, die Ermittlung des Innenwiderstands der Batteriezellen, die in einem Batteriemodul der in dem Batteriedirektkonverter vorhandenen Batterie enthalten sind, gezielt durchzuführen.

Nachteilig bei den aus dem Stand der Technik bekannten Verfahren zur Ermittlung des Innenwiderstandes der in der Batterie eines Batteriedirektkonverters enthaltenen Batteriezellen oder Batteriemodulen ist, dass sich die Ausgangsspannung der von dem Batteriedirektkonverter umfassten Batterie durch die Zuschaltung des mindestens einen Batteriemoduls, für das der Innenwiderstand seiner Batteriezellen ermittelt werden soll, deutlich erhöht.

### Offenbarung der Erfindung

Erfindungsgemäß werden ein Verfahren und eine Vorrichtung gemäß der beigefügten unabhängigen Ansprüche geschaffen.

Es wird ein Verfahren zur Ermittlung des Innenwiderstandes der Batteriezellen der in mindestens einem Batteriestrang angeordneten Batteriemodule einer mit einem Elektromotor verbundenen Batterie bereitgestellt. Dabei sind die Batteriemodule zur Erzeugung einer einstellbaren Ausgangsspannung der Batterie jeweils zu dem Batteriestrang der Batterie seriell zuschaltbar und von dem Batteriestrang entkoppelbar ausgebildet. Erfindungsgemäß wird während des Betriebs des Elektromotors mindestens ein erstes aus dem Batteriestrang entkoppeltes Batteriemodul zu dem Batteriestrang zugeschaltet und der Innenwiderstand der Batteriezellen mindestens eines ersten zugeschalteten Batteriemoduls ermittelt. Ferner werden gleichzeitig mit dem Zuschalten des ersten Batteriemoduls geeignet viele zweite Batteriemodule, die insgesamt eine Spannung erzeugen, die mit der von dem ersten Batteriemodul erzeugten Spannung innerhalb von vorbestimmten Toleranzgrenzen übereinstimmt, von dem Batteriestrang entkoppelt.

Erfindungsgemäß wird weiterhin eine Vorrichtung zur Ermittlung des Innenwiderstandes der Batteriezellen der in mindestens einem Batteriestrang angeordneten Batteriemodule einer mit einem Elektromotor verbindbaren Batterie bereitgestellt. Dabei sind die Batteriemodule zur Erzeugung einer einstellbaren Ausgangsspannung der Batterie jeweils zu dem Batteriestrang der Batterie seriell zuschaltbar oder von dem Batteriestrang entkoppelbar ausgebildet. Erfindungsgemäß ist die Vorrichtung dazu ausgebildet, während des Betriebs des Elektromotors mindestens ein erstes aus dem Batteriestrang entkoppeltes Batteriemodul zu dem Batteriestrang zuzuschalten und den Innenwiderstand der Batteriezellen mindestens eines ersten zugeschalteten Batteriemoduls zu ermitteln. Ferner ist die Vorrichtung dazu ausgebildet, gleichzeitig mit dem Zuschalten des ersten Batteriemoduls hinreichend viele zweite Batteriemodule, die insgesamt eine Spannung erzeugen, die mit der von dem ersten Batteriemodul erzeugten Spannung innerhalb von vorbestimmten Toleranzgrenzen übereinstimmt, von dem Batteriestrang zu entkoppeln.

Die Erfindung betrifft insbesondere Batterien, die im Zusammenhang mit einem Batteriedirektkonverter (BDC) betrieben werden und an einen Gleichspannungskreis eines Wechselrichters angeschlossen sind.

Insbesondere werden die Batteriezellen mindestens eines ersten zu dem Batteriestrang zugeschalteten Batteriemoduls mittels eines sprungförmigen Stroms angeregt und die von den angeregten Batteriezellen erzeugte sprungförmige Antwortspannung wird zur Ermittlung des Innenwiderstandes dieser angeregten Batteriezellen aufgezeichnet und ausgewertet.

Ein wesentlicher Vorteil der vorliegenden Erfindung ist, dass die spezifische Betriebsweise und die spezifischen Betriebsmöglichkeiten von Batteriedirektkonvertern genutzt werden, um den Innenwiderstand der Batteriezellen der Batteriemodule, die in der Batterie eines Batteriedirektkonverter vorhanden sind, möglichst einfach und genau zu ermitteln, ohne dabei die Ausgangsspannung der Batterie ändern zu müssen.

Anders ausgedrückt, es wird zur Ermittlung des Innenwiderstandes von Batteriezellen der Batteriemodule einer von einem Batteriedirektkonverter umfassten Batterie insbesondere eine sprungförmige Anregungsspannung in Form eines Stroms mit sprungförmigem Verlauf an die Batteriezellen eines Batteriemoduls angelegt, wobei ferner eine Antwort der Batteriezellen des Batteriemoduls, die in der Form einer Spannung mit einem sprungförmigen Verlauf vorliegt, aufgezeichnet und ausgewertet wird. Damit die Ausgangsspannung der von dem Batteriedirektkonverter umfassten Batterie sich nicht nennenswert ändert, wird zur Kompensation ein anderes Batteriemodul mit vergleichbarer Modulspannung abgeschaltet. Auf diese Weise kann die Ermittlung des Innenwiderstands der Batteriezellen der Batteriemodule der von einem Batteriedirektkonverter umfassten Batterie ohne Einfluss auf den Betrieb eines mit dem Batteriekonverter verbundenen Elektromotors (Elektroantrieb) durchgeführt werden.

Erfindungsgemäß wird die Erhöhung der Ausgangsspannung einer Batterie eines Batteriedirektkonverters verhindert, indem gleichzeitig mit der Zuschaltung insbesondere eines einzelnen Batteriemoduls, für das der Innenwiderstand der Batteriezellen ermittelt werden soll, ein anderes Batteriemodul mit vergleichbarer Modulspannung abgeschaltet wird.

Damit sich bei diesem Vorgang die Ausgangsspannung der Batterie des Batteriedirektkonverters nicht nennenswert ändert, müssen während des Betriebs des Batteriedirektkonverters bestimmte Randbedingungen eingehalten werden. Hierbei sind verschiedene Konzepte möglich, die im Folgenden anhand von mehreren Beispielen erläutert werden.

Dabei haben alle diese Konzepte grundsätzlich zum Ziel, in der Batterie des Batteriedirektkonverters mindestens ein Batteriemodul zur Verfügung zu stellen, welches etwa den gleichen Ladezustand beziehungsweise die gleiche Modulspannung wie jenes Batteriemodul aufweist, für das der Innenwiderstand seiner Batteriezellen ermittelt werden soll.

Bei einer besonders vorteilhaften Ausführungsform der Erfindung werden mehrere oder alle Batteriemodule des Batteriestranges mindestens einer Batteriemodulgruppe zugeordnet, wobei die Batteriemodule der Batteriemodulgruppe während des Betriebs des Elektromotors derartig eingesetzt werden, dass sie den gleichen Ladezustand und/oder die gleiche Batteriemodulspannung aufweisen. Dabei werden mindestens ein erstes Batteriemodul, für das die Ermittlung des Innenwiderstandes seiner Batteriezellen durchgeführt werden soll, und mindestens ein zweites Batteriemodul, das gleichzeitig mit dem Zuschalten des ersten Batteriemoduls zu dem Batteriestrang aus dem Batteriestrang entkoppelt werden soll, aus der Batteriemodulgruppe ausgewählt.

Vorzugsweise umfasst die Batteriemodulgruppe eine konstante Batteriemodulanzahl oder eine sich während des Betriebs des Elektromotors dynamisch verändernde Batteriemodulanzahl. Wenn mehrere Batteriemodulgruppen vorhanden sind, können mindestens zwei Batteriemodulgruppen die gleiche Batteriemodulanzahl und/oder mindestens zwei Batteriemodulgruppen eine unterschiedliche Batteriemodulanzahl aufweisen.

Anders ausgedrückt, es werden in dem Batteriedirektkonverter insbesondere mindestens zwei Batteriemodule paarweise immer so betrieben, dass sie innerhalb parametrisierbarer Grenzen den gleichen Ladezustand beziehungsweise die gleiche Modulspannung aufweisen. So werden insbesondere bei einem über eine längere Zeit eingesetzten Antrieb mittels Elektromotor, beispielsweise während einer Fahrt, erfindungsgemäß mindestens zwei Batteriemodule über die Steuerung des Batteriedirektkonverters gleichzeitig zu dem Batteriestrang zugeschaltet oder von dem Batteriestrang entkoppelt oder alternierend in kurzen Zeitständen zu dem Batteriestrang zugeschaltet beziehungsweise von dem Batteriestrang entkoppelt, um ein Auseinanderdriften der Ladezustände zu verhindern.

Ferner können auch mindestens drei Batteriemodule und maximal alle Batteriemodule des Batteriedirektkonverters als Gruppe (Cluster) auf die oben beschriebene Weise betrieben werden, wobei somit die Batteriemodule der Gruppe in etwa den gleichen Ladezustand aufweisen. Dabei können die Batteriemodule des Batteriedirektkonverters in mehrere solche Gruppen (Clustern) unterteilt werden. Die Anzahl der in einer Gruppe enthaltenen Batteriemodule kann konstant sein. Alternativ kann die Anzahl der in den verschiedenen Gruppen beteiligten Batteriemodule nicht gleich sein und sich dynamisch während des Betriebs ändern.

Weiterhin können die Batteriemodule im Batteriedirektkonverter so betrieben werden, dass sich die Ausgangsspannung der in dem Batteriedirektkonverter enthaltenen Batterie bei dem Zuschalten des Batteriemoduls, für das der Innenwiderstand seiner Batteriezellen bestimmt werden soll, nicht erhöht, wenn mindestens ein weiteres Batteriemodul zusätzlich zugeschaltet wird und mindestens zwei weitere Batteriemodule abgeschaltet werden.

Bei einer besonderen Ausführungsform der Erfindung wird zu einem bestimmten Zeitpunkt dasjenige mindestens eine erste von dem Batteriestrang entkoppelte Batteriemodul für die Ermittlung des Innenwiderstandes seiner Batteriezellen ausgewählt, für das zu dem bestimmten Zeitpunkt eine Anzahl, insbesondere ein einziges, von zweiten zugeschalteten Batteriemodulen vorhanden ist, die insgesamt eine Spannung aufweisen, die mit einer von dem ausgewählten ersten Batteriemodul erzeugbaren Spannung innerhalb von vorbestimmten Toleranzgrenzen übereinstimmt.

Bei dieser besonderen Ausführungsform ermittelt die Steuerung des Batteriedirektkonverters aus den aktuellen Modulspannungen jene Batteriemodule, deren Zuschaltung zu dem Batteriestrang durch eine gleichzeitige Abschaltung eines oder mehrerer anderer Batteriemodule von dem Batteriestrang als nahezu ausgangsneutral angesehen werden kann. Dabei kann die Innenwiderstandsbestimmung nicht für alle Batteriemodule zu beliebigen Zeitpunkten durchgeführt werden.

Ein weiterer Aspekt der Erfindung betrifft eine Batterie, die mit einem Elektromotor verbindbar ist und mehrere jeweils mindestens eine Batteriezelle umfassende Batteriemodule aufweist, die in mindestens einem Batteriestrang angeordnet sind und zur Erzeugung einer einstellbaren Ausgangsspannung der Batterie zu dem Batteriestrang der Batterie seriell zuschaltbar und von dem Batteriestrang entkoppelbar ausgebildet sind. Die Batterie weist ferner die oben beschriebene erfindungsgemäße Vorrichtung zur Ermittlung des Innenwiderstandes der Batteriezellen der Batteriemodule der Batterie auf.

Erfindungsgemäß ist die Batterie insbesondere eine Lithium-Ionen-Batterie.

Ferner betrifft die Erfindung ein Fahrzeug mit einer mit dem Elektromotor des Fahrzeuges verbindbaren Batterie mit mehreren jeweils mindestens eine Batteriezelle umfassenden Batteriemodulen, die in mindestens einem Batteriestrang angeordnet sind und zur Erzeugung einer einstellbaren Ausgangsspannung der Batterie zu dem Batteriestrang der Batterie seriell zuschaltbar und von dem Batteriestrang entkoppelbar ausgebildet sind. Die Batterie ist mit der erfindungsgemäßen Vorrichtung zur Ermittlung des Innenwiderstandes der Batteriezellen der Batteriemodule der Batterie ausgestattet.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 das Prinzipschaltbild einer im Zusammenhang mit einem Batteriedirektkonverter betriebenen und aus dem Stand der Technik bekannten Batterie, die mit einem Elektromotor verbunden ist,

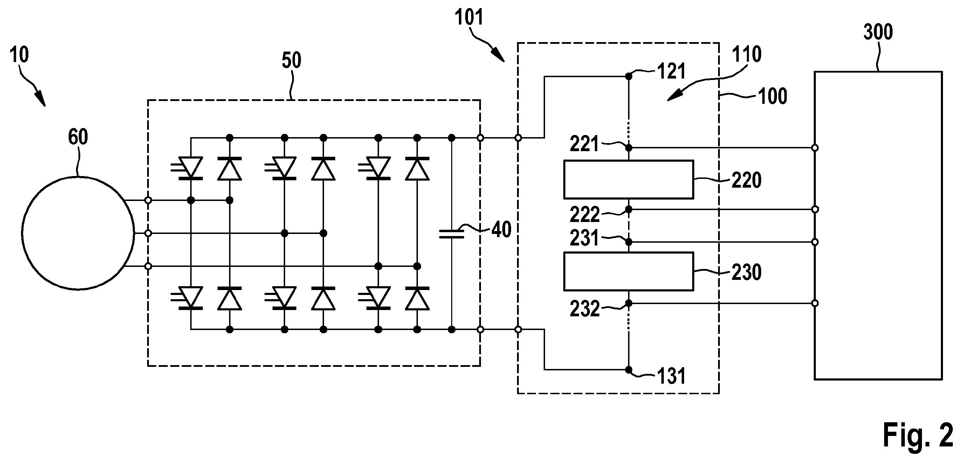

Figur 2 das Prinzipschaltbild einer mit einem Batteriedirektkonverter betriebenen Batterie, die mit einem Elektromotor und einer Vorrichtung zum Ermitteln des Innenwiderstandes der Batteriezellen der in der Batterie enthaltenen Batteriemodule verbunden ist, nach einer ersten Ausführungsform der Erfindung, und

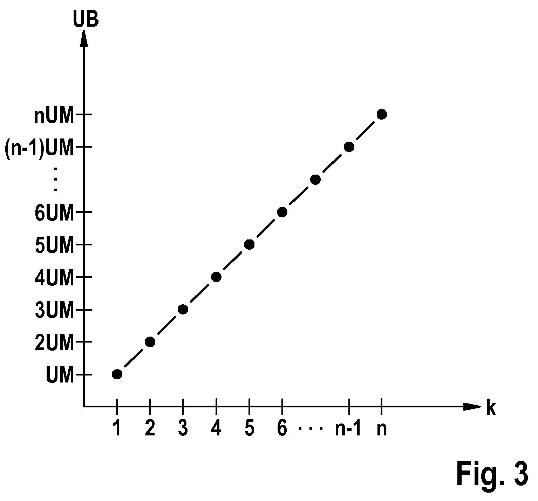

Figur 3 das Diagramm, das eine Ausgangsspannung der Batterie aus Figur 2 in Abhängigkeit von der Anzahl der zu dem Batteriestrang der Batterie zugeschalteten Batteriemodule zeigt, wobei die Batteriemodule mittels der in der Figur 2 dargestellten Vorrichtung nach der ersten Ausführungsform der Erfindung derartig während des Betriebs des Elektromotors eingesetzt werden, dass sie jeweils die gleiche Modulspannung aufweisen.

### Ausführungsformen der Erfindung

Figur 2 zeigt das Prinzipschaltbild eines Antriebssystems 10, das eine mit einem Elektromotor 60 verbundene Batterie 100 nach einer ersten Ausführungsform der Erfindung umfasst, die mit einem Batteriedirektkonverter betrieben wird. Ein Batteriesystem 101 umfasst die Batterie 100, die an einen Gleichspannungszwischenkreis (nicht gekennzeichnet), der einen Kondensator 40 umfasst, angeschlossen ist. An den Gleichspannungszwischenkreis ist auch ein von dem Batteriesystem 101 umfasster Pulswechselrichter 50 angeschlossen, der für den Betrieb eines dreiphasigen Elektromotors (elektrischer Antriebsmotor) 60 an drei Ausgängen über jeweils zwei schaltbare Halbleiterventile (nicht gekennzeichnet) und zwei Dioden (nicht gekennzeichnet) gegeneinander phasenversetzte Sinusspannungen bereitstellt.

Die Batterie 100 umfasst einen Batteriestrang 110 mit mehreren in Reihe geschalteten Batteriemodulen, von denen in der Zeichnung nur ein erstes Batteriemodul 220 und ein zweites Batteriemodul 230 explizit dargestellt sind. Die Batteriemodule 220, 230 sind zwischen einem positiven Pol 121 des Batteriestranges, der den positiven Terminal der Batterie 100 ausbildet, und einem negativen Pol 131 des Batteriestranges 110, der den negativen Terminal der Batterie ausbildet, geschaltet. Die Batteriemodule 220, 230 sind jeweils mittels einer Koppeleinrichtung (nicht dargestellt) zu dem Batteriestrang 110 zuschaltbar und von dem Batteriestrang 110 entkoppelbar. Zur Erzeugung einer gewünschten Ausgangsspannung der Batterie 100 wird eine geeignete Anzahl von Batteriemodulen 220, 230 zu dem Batteriestrang 110 zugeschaltet.

Mit der Batterie 100 ist eine Vorrichtung 300 zur Ermittlung des Innenwiderstandes von Batteriezellen (nicht dargestellt) der in der Batterie 100 enthaltenen Batteriemodule 220, 230 verbunden.

Alle ersten Batteriemodule 220 der Batterie 100 sind jeweils über die Anschlüsse 221 und 222 mit der erfindungsgemäßen Vorrichtung 300 elektrisch verbunden. Alle zweiten Batteriemodule 230 der Batterie 100 sind über die Anschlüsse 231 und 232 jeweils mit der erfindungsgemäßen Vorrichtung 300 elektrisch verbunden.

Die Vorrichtung 300 ist dazu ausgebildet, die Spannungen der einzelnen Batteriemodule 120, 130 zu messen, und umfasst ein Steuergerät (nicht dargestellt), das unter anderem Informationen über die Spannungen der Batteriemodule 220, 230 erhält und über eine Kommunikationsschnittstelle (nicht dargestellt) mit den Batteriemodulen kommuniziert.

Mittels der erfindungsgemäßen Vorrichtung 300 werden das erste Batteriemodul 220 und das zweite Batteriemodul 230 derartig während des Betriebs des Elektromotors 60 zur Erzeugung der Ausgangsspannung der Batterie 100 eingesetzt, dass das erste Batteriemodul 220 und das zweite Batteriemodul 230 immer die gleiche Modulspannung aufweisen. Dafür werden das erste Batteriemodul 220 und das zweite Batteriemodul 230 mittels des von der Vorrichtung 300 umfassten Steuergeräts gleichzeitig zu dem Batteriestrang 110 zugeschaltet oder von dem Batteriestrang 110 entkoppelt. Auch können das erste Batteriemodul 220 und das zweite Batteriemodul 230 mittels des von der Vorrichtung 300 umfassten Steuergeräts alternierend in kurzen Zeitständen zu dem Batteriestrang 110 zugeschaltet beziehungsweise von dem Batteriestrang 110 abgeschaltet werden, um ein Auseinanderdriften der Ladezustände zu verhindern.

Wenn eine Ermittlung des Innenwiderstands der Batteriezellen der ersten Batterie durchgeführt werden muss, wird mittels des von der Vorrichtung 300 umfassten Steuergeräts das von dem Batteriestrang 110 entkoppelte erste Batteriemodul 220 zugeschaltet und das zweite zu dem Batteriestrang 110 zugeschaltete Batteriemodul 230 von dem Batteriestrang 110 entkoppelt. Die Vorrichtung 300 ermittelt dann den Innenwiderstand der Batteriezellen des ersten zugeschalteten Batteriemoduls 220, indem sie die Batteriezellen des ersten zu dem Batteriestrang zugeschalteten Batteriemoduls 220 mittels eines sprungförmig verlaufenden Stroms anregt und die von den angeregten Batteriezellen erzeugte sprungförmige Antwortspannung aufzeichnet und auswertet. Während der Ermittlung des Innenwiderstandes der Batteriezellen des ersten Batteriemoduls 220 bleibt die Ausgangsspannung der Batterie 100 nahezu konstant.

Figur 3 zeigt die Ausgangsspannung UB der Batterie 100 aus der Figur 2 in Abhängigkeit von der Anzahl k der zu dem Batteriestrang 110 der Batterie 100 zugeschalteten Batteriemodule, wobei die Batteriemodule mittels der in der Figur 2 dargestellten Vorrichtung 300 derartig während des Betriebs des Elektromotors 60 eingesetzt werden, dass sie jeweils die gleiche Modulspannung UM aufweisen. Die in Abhängigkeit von der zu dem Batteriestrang 110 zugeschalteten Anzahl k von Batteriemodulen dargestellten Ausgangsspannung UB der Batterie 100 ist linear und folgt der Relation UB = k·UM, wobei 1 < k < n. Dabei ist n die maximale Anzahl der Batteriemodule, die zu dem Batteriestrang 110 zugeschaltet werden können. Die maximale Ausgangsspannung kann dann entsprechend den Wert n·UM annehmen. Die schwarzen Punkte stellen die einzelnen Messpunkte dar.

## Patentansprüche

1. Verfahren zur Ermittlung des Innenwiderstandes von in Batteriemodulen (220, 230) angeordneten Batteriezellen einer Batterie (100), wobei die Batteriemodule (220, 230) in mindestens einem Batteriestrang (110) angeordnet sind und die Batterie (100) mit einem Elektromotor (60) verbunden ist und wobei die Batteriemodule (220, 230) zur Erzeugung einer einstellbaren Ausgangsspannung (UB) der Batterie (100) jeweils dem Batteriestrang (110) der Batterie (100) seriell zugeschaltet und wieder entkoppelt werden können, **dadurch gekennzeichnet, dass** während des Betriebs des Elektromotors (60) mindestens ein erstes, aus dem Batteriestrang (110) entkoppeltes Batteriemodul (220) zu dem Batteriestrang (110) zugeschaltet wird, der Innenwiderstand von Batteriezellen des mindestens einen ersten zugeschalteten Batteriemoduls (220) ermittelt wird, und gleichzeitig mit dem Zuschalten des ersten Batteriemoduls (220) geeignet viele zweite Batteriemodule (230), die insgesamt eine Spannung (UM) erzeugen, die innerhalb von vorbestimmten Toleranzgrenzen gleich der von dem mindestens einen ersten Batteriemodul (220) erzeugten Spannung (UM) ist, von dem Batteriestrang (110) entkoppelt werden.

2. Verfahren nach Anspruch 1, wobei zur Ermittlung des Innenwiderstandes von Batteriezellen des mindestens einen ersten Batteriemoduls (220) nach dem Zuschalten zu dem Batteriestrang (110) die Batteriezellen mittels eines sprungförmigen Stroms angeregt werden und eine daraufhin von den angeregten Batteriezellen erzeugte sprungförmige Antwortspannung aufgezeichnet und ausgewertet wird.

3. Verfahren nach einem der Ansprüche 1 oder 2, wobei mehrere oder alle Batteriemodule (220, 230) eines Batteriestranges (110) mindestens einer Batteriemodulgruppe zugeordnet werden, so dass die Batteriemodule (220, 230) der Batteriemodulgruppe während des Betriebs des Elektromotors (60) derartig eingesetzt werden, dass sie den gleichen Ladezustand und/oder die gleiche Batteriemodulspannung (UM) aufweisen, wobei eines oder mehrere der zuzuschaltenden ersten Batteriemodule (220) und entsprechend viele der zu entkoppelnden zweiten Batteriemodule (230) der Batteriemodulgruppe zugeordnet sind.

4. Verfahren nach Anspruch 3, wobei die Batteriemodulgruppe eine konstante Batteriemodulanzahl oder eine sich während des Betriebs des Elektromotors dynamisch verändernde Batteriemodulanzahl aufweist.

5. Verfahren nach einem der Ansprüche 3 oder 4, wobei wenn mehrere Batteriemodulgruppen vorhanden sind, mindestens zwei Batteriemodulgruppen die jeweils gleiche Batteriemodulanzahl aufweisen und/oder mindestens zwei Batteriemodulgruppen eine jeweils unterschiedliche Batteriemodulanzahl aufweisen.

6. Verfahren nach einem der Ansprüche 1 oder 2, wobei das Verfahren derart durchgeführt wird, dass das mindestens eine erste, zunächst von dem Batteriestrang (110) entkoppelte Batteriemodul (220) zu einem derart gewählten Zeitpunkt für die Ermittlung des Innenwiderstandes von Batteriezellen zum Zuschalten zu dem Batteriestrang ausgewählt wird, zu dem die zweiten Batteriemodule (230) insgesamt eine Spannung (UM) aufweisen, die innerhalb der vorbestimmten Toleranzgrenzen gleich der Spannung (UM) des mindestens einen ausgewählten ersten Batteriemoduls (220) ist.

7. Vorrichtung (300) zur Ermittlung des Innenwiderstandes der Batteriezellen der in mindestens einem Batteriestrang (110) angeordneten Batteriemodule (220, 230) einer mit einem Elektromotor (60) verbindbaren Batterie (100), wobei die Batteriemodule (220, 230) zur Erzeugung einer einstellbaren Ausgangsspannung (UB) der Batterie (100) jeweils zu dem Batteriestrang (110) der Batterie (100) seriell zuschaltbar und von dem Batteriestrang (110) entkoppelbar ausgebildet sind, **dadurch gekennzeichnet, dass** die Vorrichtung (300) dazu ausgebildet ist, während des Betriebs des Elektromotors (60) mindestens ein erstes, aus dem Batteriestrang (110) entkoppeltes Batteriemodul (220) zu dem Batteriestrang (110) zuzuschalten, den Innenwiderstand von Batteriezellen des mindestens einen ersten zugeschalteten Batteriemoduls (220) zu ermitteln, und gleichzeitig mit dem Zuschalten des ersten Batteriemoduls (220) geeignet viele zweite Batteriemodule (230), die insgesamt eine Spannung (UM) erzeugen, die innerhalb von vorbestimmten Toleranzgrenzen gleich der von dem ersten Batteriemodul (220) erzeugten Spannung (UM) ist, von dem Batteriestrang (110) zu entkoppeln.

8. Vorrichtung nach Anspruch 7, wobei die Vorrichtung (300) ferner dazu ausgebildet ist, Batteriezellen des mindestens eines ersten Batteriemoduls (220) mittels eines sprungförmigen Stroms anzuregen und eine daraufhin von den angeregten Batteriezellen erzeugte sprungförmige Antwortspannung zur Ermittlung des Innenwiderstands der angeregten Batteriezellen aufzuzeichnen und auszuwerten.

9. Vorrichtung nach einem der Ansprüche 7 oder 8, wobei die Vorrichtung (300) weiter dazu ausgebildet ist, von den Batteriemodulen (220, 230) des Batteriestranges (110) eine konstante oder eine sich während des Betriebs des Elektromotors (60) ändernde Batteriemodulanzahl auszuwählen und mindestens einer Batteriemodulgruppe zuzuordnen und die der Batteriemodulgruppe zugeordneten Batteriemodule (220, 230) während des Betriebs des Elektromotors (60) derartig einzusetzen, dass sie jeweils den gleichen Ladezustand und/oder die gleiche Batteriemodulspannung (UM) aufweisen, wobei eines oder mehrere der zuzuschaltenden ersten Batteriemodule (220) und entsprechend viele der zu entkoppelnden zweiten Batteriemodule (230) aus der Batteriemodulgruppe ausgewählte Batteriemodule (220, 230) sind.

10. Vorrichtung (300) nach Anspruch 7, wobei die Vorrichtung (300) weiter dazu ausgebildet ist, das mindestens eine erste von dem Batteriestrang (110) entkoppelte Batteriemodul (220) zu einem derartig gewählten Zeitpunkt für die Ermittlung des Innenwiderstandes seiner Batteriezellen zum Zuschalten zu dem Batteriestrang auszuwählen, zu dem die zweiten Batteriemodule (230) insgesamt eine Spannung (UM) aufweisen, die innerhalb der vorbestimmten Toleranzgrenzen gleich der Spannung (UM) des mindestens einen ausgewählten ersten Batteriemoduls (220) ist.

11. Batterie (100), die mehrere jeweils mindestens eine Batteriezelle umfassende Batteriemodule (220, 230) aufweist, die in mindestens einem Batteriestrang (110) angeordnet sind und zur Erzeugung einer einstellbaren Ausgangsspannung (UB) der Batterie (100) zu dem Batteriestrang (110) der Batterie (100) seriell zuschaltbar und wieder von dem Batteriestrang (110) entkoppelbar ausgebildet sind, **dadurch gekennzeichnet, dass** die Batterie (100) die Vorrichtung (300) nach einem der Ansprüche 7 bis 10 aufweist.

12. Kraftfahrzeug mit der Batterie (100) nach Anspruch 11, wobei die Batterie (100) in einem Antriebssystem des Fahrzeugs angeordnet ist.

## Claims

1. Method for determining the internal resistance of battery cells, arranged in battery modules (220, 230), of a battery (100), wherein the battery modules (220, 230) are arranged in at least one battery bank (110) and the battery (100) is connected to an electric motor (60), and wherein the battery modules (220, 230), in order to generate an adjustable output voltage (UB) of the battery (100), are designed such that they can each be connected in series to the battery bank (110) of the battery (100) and decoupled again, **characterized in that**, during the operation of the electric motor (60), at least one first battery module (220) decoupled from the battery bank (110) is connected to the battery bank (110), the internal resistance of battery cells of the at least one first connected battery module (220) is determined, and, at the same time as the connection of the first battery module (220), a suitable number of second battery modules (230), which on the whole generate a voltage (UM) which is the same as the voltage (UM) generated by the at least one first battery module (220) within predetermined tolerance limits, are decoupled from the battery bank (110).

2. Method according to Claim 1, wherein, in order to determine the internal resistance of battery cells of the at least one first battery module (220) following the connection to the battery bank (110), the battery cells are excited by means of a stepped current, and a stepped response voltage generated thereupon by the excited battery cells is recorded and evaluated.

3. Method according to either of Claims 1 and 2, wherein a number of, or all, battery modules (220, 230) of a battery bank (110) are assigned to at least one battery module group, such that the battery modules (220, 230) of the battery module group are used during operation of the electric motor (60) in such a way that they have the same state of charge and/or the same battery module voltage (UM), wherein one or more of the first battery modules (220) to be connected and a corresponding, number of second battery modules (230) to be decoupled are assigned to the battery module group.

4. Method according to Claim 3, wherein the battery module group has a constant battery module number or a battery module number changing dynamically during the operation of the electric motor.

5. Method according to either of Claims 3 and 4, wherein, when a number of battery module groups are provided, at least two battery module groups each have the same battery module number and/or at least two battery module groups each have a different battery module number.

6. Method according to either of Claims 1 and 2, wherein the method is carried out in such a way that the at least one first battery module (220) firstly decoupled from the battery bank (110) is selected for connection to the battery bank for the determination of the internal resistance of battery cells at a moment in time at which the second battery modules (230) on the whole have a voltage (UM) that is the same as the voltage (UM) of the at least one selected first battery module (220) within the predetermined tolerance limits.

7. Device (300) for determining the internal resistance of the battery cells of the battery modules (220, 230), arranged in at least one battery bank (110), of a battery (100) connectable to an electric motor (60), wherein, in order to generate an adjustable output voltage (UB) of the battery (100), the battery modules (220, 230) can be connected in series to the battery bank (110) of the battery (100) and can be decoupled from the battery bank (110), **characterized in that** the device (300) is designed, during operation of the electric motor (60), to connect to the battery bank (110) at least one first battery module (220) decoupled from the battery bank (110), to determine the internal resistance of battery cells of the at least one first connected battery module (220), and, at the same time as the connection of the first battery module (220), to decouple from the battery bank (110) a suitable number of second battery modules (230), which on the whole generate a voltage (UM) that is the same as the voltage (UM) generated by the first battery module (220) within predetermined tolerance limits.

8. Device according to Claim 7, wherein the device (300) is also designed to excite battery cells of the at least one first battery module (220) by means of a stepped current and to record and evaluate a stepped response voltage, generated thereupon by the excited battery cells, in order to determine the internal resistance of the excited battery cells.

9. Device according to either of Claims 7 and 8, wherein the device (300) is further designed, from the battery modules (220, 230) of the battery bank (110), to select a constant battery module number or a battery module number changing during the operation of the electric motor (60) and to assign this battery module number to at least one battery module group, and, during operation of the electric motor (60), to use the battery modules (220, 230) assigned to the battery module group in such a way that they each have the same state of charge and/or the same battery module voltage (UM), wherein one or more of the first battery modules (220) to be connected and a corresponding number of second battery modules (230) to be decoupled are battery modules (220, 230) selected from the battery module group.

10. Device (300) according to Claim 7, wherein the device (300) is also designed to select the at least one first battery module (220), decoupled from the battery bank (110), for connection to the battery bank for the determination of the internal resistance of the battery cells of said first battery module at a moment in time at which the second battery modules (230) on the whole have a voltage (UM) that is the same as the voltage (UM) of the at least one selected first battery module (220) within the predetermined tolerance limits.

11. Battery (100), which has a number of battery modules (220, 230), which each comprise at least one battery cell, are arranged in at least one battery bank (110) and, in order to generate an adjustable output voltage (UB) of the battery (100), are designed such that they can be connected in series to the battery bank (110) of the battery (100) and can be decoupled again from the battery bank (110), **characterized in that** the battery (100) comprises the device (300) according to one of Claims 7 to 10.

12. Motor vehicle having the battery (100) according to Claim 11, wherein the battery (100) is arranged in a drive system of the vehicle.

## Revendications

1. Procédé de détermination de la résistance interne des cellules de batterie d'une batterie (100) disposées dans des modules de batterie (220, 230), les modules de batterie (220, 230) étant disposés dans au moins une branche de batterie (110) et la batterie (100) étant reliée à un moteur électrique (60) et les modules de batterie (220, 230) pouvant respectivement être connectés en série avec la branche de batterie (110) de la batterie (100) et en être de nouveau déconnectés en vue de générer une tension de sortie (UB) réglable de la batterie (100), **caractérisé en ce que** pendant le fonctionnement du moteur électrique (60), au moins un premier module de batterie (220) déconnecté de la branche de batterie (110) est connecté à la branche de batterie (110), la résistance interne des cellules de batterie de l'au moins un premier module de batterie (220) connecté est déterminée et un nombre approprié de deuxièmes modules de batterie (230), lesquels génèrent ensemble une tension (UM) qui est, dans des limites de tolérance prédéfinies, égale à la tension (UM) générée par l'au moins un premier module de batterie (220), sont déconnectés de la branche de batterie (110) simultanément avec la connexion du premier module de batterie (220).

2. Procédé selon la revendication 1, dans lequel, en vue de déterminer la résistance interne des cellules de batterie de l'au moins un premier module de batterie (220), après la connexion à la branche de batterie (110), les cellules de batterie sont excitées au moyen d'un courant en forme de saut et une tension en forme de saut générée ensuite par les cellules de batterie excitées est enregistrée et interprétée.

3. Procédé selon l'une des revendications 1 ou 2, plusieurs ou la totalité des modules de batterie (220, 230) d'une branche de batterie (110) étant associés à au moins un groupe de modules de batterie, de sorte que les modules de batterie (220, 230) du groupe de modules de batterie sont utilisés pendant le fonctionnement du moteur électrique (60) de telle sorte qu'ils présentent le même état de charge et/ou la même tension de module de batterie (UM), un ou plusieurs des premiers modules de batterie (220) à connecter et un nombre correspondant des deuxièmes modules de batterie (230) à déconnecter étant associés au groupe de modules de batterie.

4. Procédé selon la revendication 3, le groupe de modules de batterie possédant un nombre de modules de batterie constant ou un nombre de modules de batterie qui varie dynamiquement pendant le fonctionnement du moteur électrique.

5. Procédé selon l'une des revendications 3 ou 4, plusieurs groupes de modules de batterie étant présents, au moins deux groupes de modules de batterie possédant respectivement le même nombre de modules de batterie et/ou au moins deux groupes de modules de batterie possédant respectivement un nombre différent de modules de batterie.

6. Procédé selon l'une des revendications 1 ou 2, le procédé étant mis en oeuvre de telle sorte qu'au moins un premier module de batterie (220) déconnecté initialement de la branche de batterie (110) est sélectionné pour la détermination de la résistance interne des cellules de batterie en vue d'être connecté à la branche de batterie à un instant choisi de telle sorte que les deuxièmes modules de batterie (230) présentent en tout une tension (UM) qui est, dans des limites de tolérance prédéfinies, égale à la tension (UM) générée par l'au moins un premier module de batterie (220) sélectionné.

7. Dispositif (300) de détermination de la résistance interne des cellules de batterie des modules de batterie (220, 230) disposés dans au moins une branche de batterie (110) d'une batterie (100) pouvant être reliée à un moteur électrique (60), les modules de batterie (220, 230) étant configurés pour pouvoir respectivement être connectés en série avec la branche de batterie (110) de la batterie (100) et être déconnectés de la branche de batterie (110) en vue de générer une tension de sortie (UB) réglable de la batterie (100), **caractérisé en ce que** le dispositif (300) est configuré pour, pendant le fonctionnement du moteur électrique (60), connecter à la branche de batterie (110) au moins un premier module de batterie (220) déconnecté de la branche de batterie (110), déterminer la résistance interne des cellules de batterie de l'au moins un premier module de batterie (220) connecté et, simultanément avec la connexion du premier module de batterie (220), déconnecter de la branche de batterie (110) un nombre approprié de deuxièmes modules de batterie (230), lesquels génèrent ensemble une tension (UM) qui est, dans des limites de tolérance prédéfinies, égale à la tension (UM) générée par le premier module de batterie (220).

8. Dispositif selon la revendication 7, le dispositif (300) étant en outre configuré pour exciter les cellules de batterie de l'au moins un premier module de batterie (220) au moyen d'un courant en forme de saut et pour enregistrer et interpréter une tension en forme de saut qui est ensuite générée par les cellules de batterie excitées en vue de déterminer la résistance interne des cellules de batterie excitées.

9. Dispositif selon l'une des revendications 7 ou 8, le dispositif (300) étant en outre configuré pour sélectionner parmi les modules de batterie (220, 230) de la branche de batterie (110) un nombre de modules de batterie constant ou qui varie pendant le fonctionnement du moteur électrique (60) et les associer à au moins un groupe de modules de batterie, et pour utiliser les modules de batterie (220, 230) associés au groupe de modules de batterie pendant le fonctionnement du moteur électrique (60) de telle sorte qu'ils présentent respectivement le même état de charge et/ou la même tension de module de batterie (UM), un ou plusieurs des premiers modules de batterie (220) à connecter et un nombre correspondant des deuxièmes modules de batterie (230) à déconnecter étant des modules de batterie (220, 230) sélectionnés dans le groupe de modules de batterie.

10. Dispositif (300) selon la revendication 7, le dispositif (300) étant en outre configuré pour sélectionner, en vue de sa connexion à la branche de batterie, l'au moins un premier module de batterie (220) déconnecté de la branche de batterie (110) pour la détermination de la résistance interne de ses cellules de batterie à un instant choisi de telle sorte que les deuxièmes modules de batterie (230) présentent en tout une tension (UM) qui est, dans des limites de tolérance prédéfinies, égale à la tension (UM) générée par l'au moins un premier module de batterie (220) sélectionné.

11. Batterie (100) possédant plusieurs modules de batterie (220, 230) comprenant respectivement au moins une cellule de batterie, lesquels sont disposés dans au moins une branche de batterie (110) et sont configurés pour pouvoir être connectés en série avec la branche de batterie (110) de la batterie (100) et être de nouveau déconnectés de la branche de batterie (110) en vue de générer une tension de sortie (UB) réglable de la batterie (100), **caractérisée en ce que** la batterie (100) possède le dispositif (300) selon l'une des revendications 7 à 10.

12. Véhicule automobile équipé de la batterie (100) selon la revendication 11, la batterie (100) étant disposée dans un système propulseur du véhicule.
